# EUROPEAN PATENT APPLICATION

(11) **EP 4 648 196 A1**
(43) Date of publication of application: **12.11.2025**
(21) Application number: 24887677.3
(22) Date of filing: 30.09.2024
(51) Int. Cl.: H01M 50/247

(54) **BATTERY PACK FOR POWERING ELECTRIC TOOL**

(30) Priority: 10.11.2023 CN 202311499218
(71) Applicant: Nanjing Chervon Industry Co., Ltd., Nanjing, Jiangsu 211106 (CN)
(72) Inventor: GONG, Binbin, Nanjing, Jiangsu 211106 (CN); HU, Guiwu, Nanjing, Jiangsu 211106 (CN); YANG, Dong, Nanjing, Jiangsu 211106 (CN)
(74) Representative: Sun, Yiming
(86) International application number: PCT/CN2024/122696
(87) International publication number: WO 2025/098063

(57) **Abstract**

A battery pack for powering a power tool includes: a housing; a terminal assembly configured to be connected to a tool terminal of the power tool to transmit electric energy; and a cell module accommodated in the housing and electrically connected to the terminal assembly, where the cell module includes at least multiple cell units. The energy density per unit volume of the battery pack is greater than or equal to 110 mWh/cm³.

## Description

This application claims priority to Chinese Patent Application No. 202311499218.1 filed with the China National Intellectual Property Administration (CNIPA) on Nov. 10, 2023, the disclosure of which is incorporated herein by reference in its entirety.

### TECHNICAL FIELD

The present application relates to the technical field of electric energy storage, for example, a battery pack for powering a power tool.

### BACKGROUND

With the development of battery technology, engine tools are gradually replaced with power tools. Based on the use requirement for portability, more and more power tools use battery packs as power sources.

In the related art, battery packs for powering power tools mostly use cylindrical lithium cells. Multiple cylindrical lithium cells are connected in series and in parallel to ensure sufficient electric power output so that the endurance capacity of a power tool is improved.

The housings of the cylindrical lithium cells are generally made of a rigid metal, which results in a relatively large mass of an entire battery pack. When using the machine, a user needs to overcome great gravity to operate the machine, which affects the user experience.

This part provides background information related to the present application, and the background information is not necessarily the existing art.

### SUMMARY

An object of the present application is to solve or at least alleviate part or all of the preceding problems. Therefore, an object of the present application is to provide a soft pack for a power tool.

To achieve the preceding object, the present application adopts the technical solutions below.

A battery pack for powering a power tool includes: a housing; a terminal assembly configured to be connected to a tool terminal of the power tool to transmit electric energy; and a cell module accommodated in the housing and electrically connected to the terminal assembly, where the cell module includes at least multiple cell units. The energy density per unit volume of the battery pack is greater than or equal to 110 mWh/cm³.

In an example, the energy density per unit height of the battery pack in an up and down direction is greater than or equal to 950 mWh/mm.

In an example, the multiple cell units are pouch cells.

In an example, at least the bottom of the housing is provided with a stiffener.

In an example, the ratio of the surface area of the stiffener to the area of the bottom of the housing is less than or equal to 0.8.

In an example, the ratio of the thickness of the stiffener to the thickness of the bottom of the housing is less than or equal to 0.4.

In an example, the stiffener is embedded in the bottom of the housing.

In an example, a tab extends from an end of each of the multiple cell units, and the battery pack further includes a guide structure, where the guide structure is disposed at the front end of the tab in the extension direction to guide or support the tab.

A battery pack for powering a power tool includes: a housing; a terminal assembly configured to be connected to a tool terminal of the power tool to transmit electric energy; a cell module accommodated in the housing, where the cell module includes at least multiple cell units, and each of the multiple cell units has a first tab and a second tab; and a circuit board assembly. The circuit board assembly includes: an output circuit board connected to at least the terminal assembly to carry outputted electric energy of the battery pack; a tab circuit board electrically coupled to at least the first tab and the second tab; and a battery management circuit board carrying at least a battery management module of the battery pack. The tab circuit board is provided with a first slot through which the first tab penetrates and a second slot through which the second tab penetrates, and the length of the first slot is different from the length of the second slot.

In an example, the battery pack further includes: a cell bracket configured to wrap at least part of the cell module; the output circuit board disposed at the upper end of the cell bracket; the tab circuit board disposed at the front end of the cell module and substantially perpendicular to the output circuit board; and the battery management circuit board disposed in front of the tab circuit board and substantially parallel to the tab circuit board.

In an example, the battery pack further includes a circuit board support, where the circuit board support is configured to surround the periphery of the battery management circuit board to support the battery management circuit board.

In an example, the battery pack further includes a latch assembly configured to be capable of locking at least the battery pack to the power tool, where the latch assembly includes an elastic member and an operation member for a user to operate, and the elastic member is mounted on the circuit board support.

In an example, an effective interference stroke by which the operation member is mounted to the housing is less than or equal to 2 mm.

In an example, the distance range between the tab circuit board and the battery management circuit board is less than or equal to 10 mm.

In an example, a single-cell signal line is connected between the tab circuit board and the battery management circuit board, and the length of the single-cell signal line is less than or equal to 30 mm.

In an example, the battery pack further includes: multiple light-emitting members disposed on the battery management circuit board; a light guide member at least partially located on the multiple light-emitting members; and an electronic display button mounted on the housing and used by the user to operate an electronic display element on the battery management circuit board, where the light guide member is formed with a limit rib to limit the electronic display button.

In an example, the battery pack further includes a sponge disposed on the battery management circuit board, where the sponge is configured to isolate at least the multiple light-emitting members.

A battery pack for powering a power tool includes: a housing, where multiple insertion slots are provided at the upper end of the housing; a terminal assembly disposed in the housing and including multiple battery terminals, where positions where the multiple battery terminals are mounted in the housing correspond to the multiple insertion slots; and a cell module accommodated in the housing, where the cell module includes at least multiple cell units, and a first tab and a second tab extend from an end of each of the multiple of cell units. The opening direction of each of the multiple insertion slots is opposite to the extension direction of the first tab and the extension direction of the second tab.

In an example, the ratio of the opening width of each of the multiple insertion slots to the distance between two adjacent insertion slots is less than or equal to 0.2.

A battery pack includes: a housing; a terminal assembly configured to be connected to a tool terminal of the power tool to transmit electric energy; and a cell module accommodated in the housing, where the cell module includes at least multiple cell units. The multiple cell units are pouch cells, and the battery pack is continuously discharged at a discharge rate of greater than or equal to 30 C at room temperature for a period of longer than or equal to 20s.

### BRIEF DESCRIPTION OF DRAWINGS

To illustrate technical solutions in examples of the present application more clearly, the drawings used in the description of the examples are briefly described below. Apparently, the drawings described below illustrate only part of the examples of the present application, and those of ordinary skill in the art may obtain other drawings based on the drawings described below on the premise that no creative work is done.
FIG. 1 is a structural view showing a system formed by a battery pack and a power tool according to an example of the present application.
FIG. 2 is an exploded view of the battery pack in FIG. 1.
FIG. 3 is a top view of the battery pack in FIG. 1.
FIG. 4 is a view showing some structures of the battery pack in FIG. 1.
FIG. 5 is a structural view of a battery unit within the battery pack in FIG. 1.
FIG. 6 is a sectional view of the battery pack in FIG. 1 from an angle of view.
FIG. 7 is a structural view of a guide structure within the battery pack in FIG. 1.
FIG. 8 is a structural view of a tab circuit board within the battery pack in FIG. 1.
FIG. 9 is a structural view of a circuit board support and a battery management circuit board within the battery pack in FIG. 1.
FIG. 10 is an exploded view showing some structures within the battery pack in FIG. 1.
FIG. 11 is a schematic view showing the assembly of a light guide member and an electronic display button of the battery pack in FIG. 1.

### DETAILED DESCRIPTION

Before any examples of this application are explained in detail, it is to be understood that this application is not limited to its application to the structural details and the arrangement of components set forth in the following description or illustrated in the above drawings.

In this application, the terms "comprising", "including", "having" or any other variation thereof are intended to cover an inclusive inclusion such that a process, method, article or device comprising a series of elements includes not only those series of elements, but also other elements not expressly listed, or elements inherent in the process, method, article, or device. Without further limitations, an element defined by the phrase "comprising a ..." does not preclude the presence of additional identical elements in the process, method, article, or device comprising that element.

In this application, the term "and/or" is a kind of association relationship describing the relationship between associated objects, which means that there can be three kinds of relationships. For example, Aand/or B can indicate that A exists alone, A and B exist simultaneously, and B exists alone. In addition, the character "/" in this application generally indicates that the contextual associated objects belong to an "and/or" relationship.

In this application, the terms "connection", "combination", "coupling" and "installation" may be direct connection, combination, coupling or installation, and may also be indirect connection, combination, coupling or installation. Among them, for example, direct connection means that two members or assemblies are connected together without intermediaries, and indirect connection means that two members or assemblies are respectively connected with at least one intermediate members and the two members or assemblies are connected by the at least one intermediate members. In addition, "connection" and "coupling" are not limited to physical or mechanical connections or couplings, and may include electrical connections or couplings.

In this application, it is to be understood by those skilled in the art that a relative term (such as "about", "approximately", and "substantially") used in conjunction with quantity or condition includes a stated value and has a meaning dictated by the context. For example, the relative term includes at least a degree of error associated with the measurement of a particular value, a tolerance caused by manufacturing, assembly, and use associated with the particular value, and the like. Such relative term should also be considered as disclosing the range defined by the absolute values of the two endpoints. The relative term may refer to plus or minus of a certain percentage (such as 1%, 5%, 10%, or more) of an indicated value. A value that did not use the relative term should also be disclosed as a particular value with a tolerance. In addition, "substantially" when expressing a relative angular position relationship (for example, substantially parallel, substantially perpendicular), may refer to adding or subtracting a certain degree (such as 1 degree, 5 degrees, 10 degrees or more) to the indicated angle.

In this application, those skilled in the art will understand that a function performed by an assembly may be performed by one assembly, multiple assemblies, one member, or multiple members. Likewise, a function performed by a member may be performed by one member, an assembly, or a combination of members.

In this application, the terms "up", "down", "left", "right", "front", and "rear" and other directional words are described based on the orientation or positional relationship shown in the drawings, and should not be understood as limitations to the examples of this application. In addition, in this context, it also needs to be understood that when it is mentioned that an element is connected "above" or "under" another element, it can not only be directly connected "above" or "under" the other element, but can also be indirectly connected "above" or "under" the other element through an intermediate element. It should also be understood that orientation words such as upper side, lower side, left side, right side, front side, and rear side do not only represent perfect orientations, but can also be understood as lateral orientations. For example, lower side may include directly below, bottom left, bottom right, front bottom, and rear bottom.

In this application, the terms "controller", "processor", "central processor", "CPU" and "MCU" are interchangeable. Where a unit "controller", "processor", "central processing", "CPU", or "MCU" is used to perform a specific function, the specific function may be implemented by a single aforementioned unit or a plurality of the aforementioned unit.

In this application, the term "device", "module" or "unit" may be implemented in the form of hardware or software to achieve specific functions.

In this application, the terms "computing", "judging", "controlling", "determining", "recognizing" and the like refer to the operations and processes of a computer system or similar electronic computing device (e.g., controller, processor, etc.).

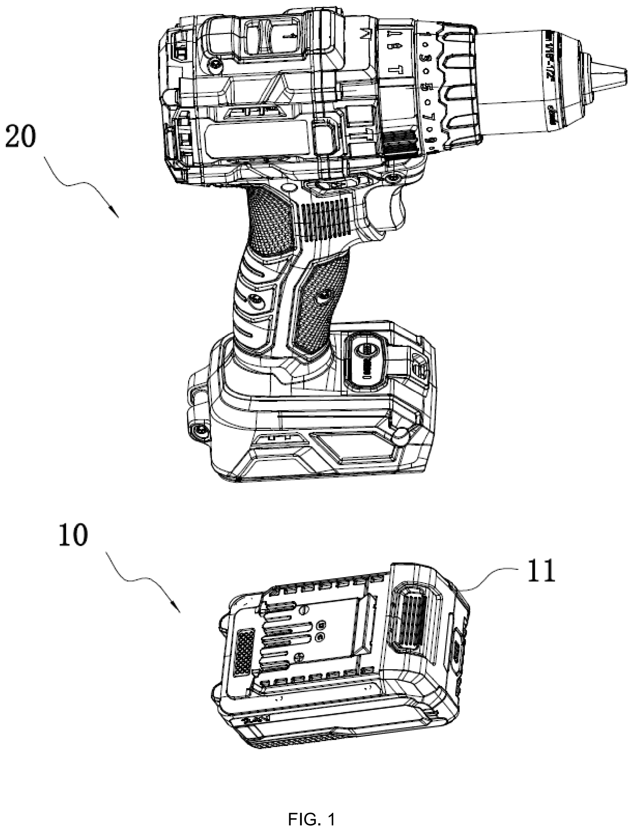

FIG. 1 shows a power tool 20 and a battery pack 10 that is adaptable to and powers the power tool 20. The rated voltage of the battery pack 10 may be 10.8 V, 24 V, 36 V, 48 V, 56 V, or 80 V, which is not limited here. The capacity of the battery pack 10 is greater than or equal to 2 Ah. In FIG. 1, the power tool 20 is an electric drill. However, it is to be understood that the present application is not limited to the disclosed examples but is applicable to other types of power tools, for example, an electric drill, a pruner, or a sander. Alternatively, the power tool 20 may be a table tool, such as a table saw or a miter saw. Alternatively, the power tool 20 may be a push power tool, such as a push mower or a push snow thrower. Alternatively, the power tool 20 may be a riding power tool, such as a riding mower, a riding vehicle, or an all-terrain vehicle. Alternatively, the power tool 20 may be a robotic tool, such as a robotic mower or a robotic snow thrower. In some examples, the power tool 20 may be an electric drill, an electric lamp, an electric vehicle, or the like. In some examples, the power tool 20 may be a garden tool, such as a pruner, a blower, a mower, or a chainsaw. Alternatively, the power tool 20 may be a decorating tool, such as a screwdriver, a nail gun, a circular saw, or a sander. In some examples, the power tool 20 may be a vegetation care tool, such as a string trimmer, a mower, a pruner, or a chainsaw. Alternatively, the power tool 20 may be a cleaning tool, such as a blower, a snow thrower, or a cleaning machine. Alternatively, the power tool 20 may be a drilling tool, such as a drill, a screwdriver, a wrench, or an electric hammer. Alternatively, the power tool 20 may be a sawing tool such as a reciprocating saw, a jigsaw, or a circular saw. Alternatively, the power tool 20 may be a table tool, such as a table saw, a miter saw, a metal cutter, or an electric router. Alternatively, the power tool 20 may be a sanding tool such as an angle grinder or a sander. Alternatively, the power tool 20 may be another tool, such as a lamp or a fan.

In this example, the energy density per unit volume of the battery pack 10 is greater than or equal to 110 mWh/cm³. In an example, the energy density per unit volume of the battery pack 10 is greater than or equal to 120 mWh/cm³, or greater than or equal to 130 mWh/cm³, or greater than or equal to 140 mWh/cm³, or greater than or equal to 150 mWh/cm³, or greater than or equal to 160 mWh/cm³, or greater than or equal to 170 mWh/cm³, and so on. Thus, the battery pack 10 is enabled to better cope with a working condition that has a requirement on a volume when adapted to the power tool.

In this example, the energy density per unit height of the battery pack 10 in an up and down direction is greater than or equal to 950 mWh/mm. In an example, the energy density per unit height of the battery pack 10 is greater than or equal to 1000 mWh/mm, or greater than or equal to 1100 mWh/mm, or greater than or equal to 1200 mWh/mm, or greater than or equal to 1300 mWh/mm, and so on. Thus, the battery pack 10 is enabled to better cope with a working condition that has a requirement on a height when adapted to the power tool.

In this example, the battery pack 10 powers the power tool 20 at a discharge rate of greater than or equal to 30 C at room temperature for a duration of longer than or equal to 20s. The room temperature may be a temperature of about 25 °C, or a temperature of about 20 °C, or a temperature of about 30 °C, and the like. Thus, the battery pack 10 can supply more energy to the power tool so that the power tool operates for a longer time.

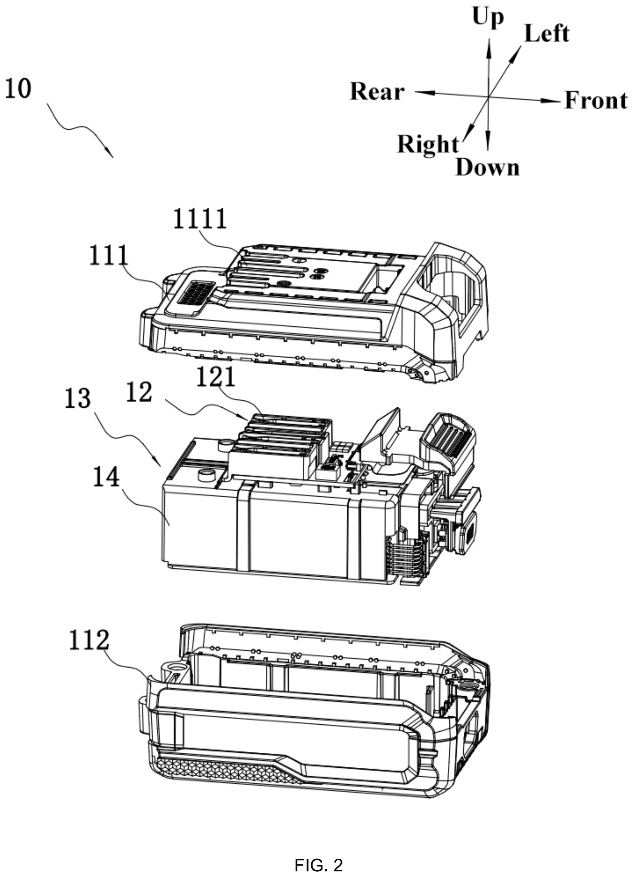

Referring to FIGS. 2 to 6, the battery pack 10 includes a housing 11, a terminal assembly 12, a cell module 13, and a cell bracket 14 supporting the cell module 13.

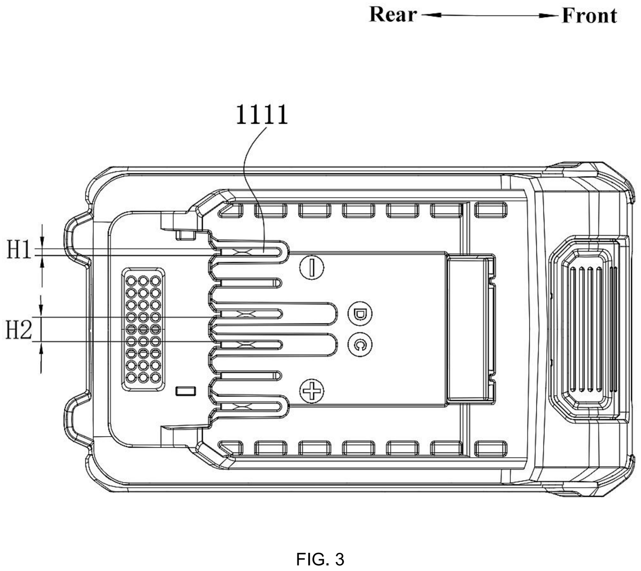

The terminal assembly 12 may include at least multiple battery terminals 121. For example, the terminal assembly 12 includes at least positive/negative terminals and a communication terminal. The battery pack 10 outputs electric energy to the power tool 20 through the terminal assembly 12. In other examples, the battery pack 10 may also be connected to a charger through the terminal assembly 12 to acquire charging electric energy or be connected to an adapter. The housing 11 includes an upper housing 111 and a lower housing 112. The upper housing 111 and the lower housing 112 are assembled to form an accommodating space for fixing and accommodating the cell module 13. Multiple insertion slots 1111 are formed on the upper surface of the upper housing 111. Openings of the insertion slots 1111 are configured to accommodate or expose the battery terminals 121. Tool terminals on the power tool 20 can be electrically coupled to the battery terminals 121 through the insertion slots 1111. In this example, the number of the insertion slots 1111 is the same as the number of the battery terminals 121. Referring to FIG. 3, the ratio of the opening width H1 of each of the insertion slots 1111 to the distance H2 between two adjacent insertion slots 1111 is less than or equal to 0.2. For example, the ratio of H1 to H2 is less than or equal to 0.15 or less than or equal to 0.1. For example, the ratio of H1 to H2 may be 0.1, 0.15, or 0.2. In this example, the insertion slots 1111 are open toward a rear end. That is to say, the battery pack 10 can be coupled to the power tool 20 or other electrical equipment from front to back.

In this example, at least the bottom of the lower housing 112 is provided with a stiffener (not shown) to enhance the strength of the housing 11 and prevent the housing 11 from being punctured. In other examples, a stiffener may also be disposed on a side surface or the upper surface of the housing 11 of the battery pack. In an example, the stiffener may be a metal sheet attached to the inner side of the housing 11 or a metal layer embedded in the housing 11. For example, the stiffener may be a steel sheet or a steel layer. The stiffener may be a regular sheet or a square sheet or may be an irregular sheet or a net-like sheet. In this example, the ratio of the bottom area of the stiffener laid flat at the bottom of the housing 11 to the area of the bottom of the housing 11, that is, the area of the bottom of the lower housing 112, is less than 1, or less than or equal to 0.9, or less than or equal to 0.8, or less than or equal to 0.7, or less than or equal to 0.6, or less than or equal to 0.5. The ratio of the thickness of the stiffener to the thickness of the bottom of the housing 11, that is, the thickness of the lower housing 112, is less than or equal to 0.4, or less than or equal to 0.3, or less than or equal to 0.2, and so on. In some examples, the thickness of the stiffener to the ratio of the bottom area of the stiffener to the area of the bottom of the housing 112 may be configured according to a specific shape of the housing 11 of the battery pack 10 or a working condition or a power tool to which the battery pack 10 is applicable.

The cell bracket 14 is at least configured to support or fix the position of the cell module 13 in the housing 11 or can surround at least part of the cell module 13. Referring to FIG. 2, the cell bracket 14 in this example may be a cell housing and at least substantially surrounds the cell module 13. In this example, the terminal assembly 12 is disposed at the upper end of the cell bracket 14. In this example, the cell bracket 14 may be a hard bracket made of a plastic material or may be made of other materials. The structure of the cell bracket 14 is not specifically limited in this example.

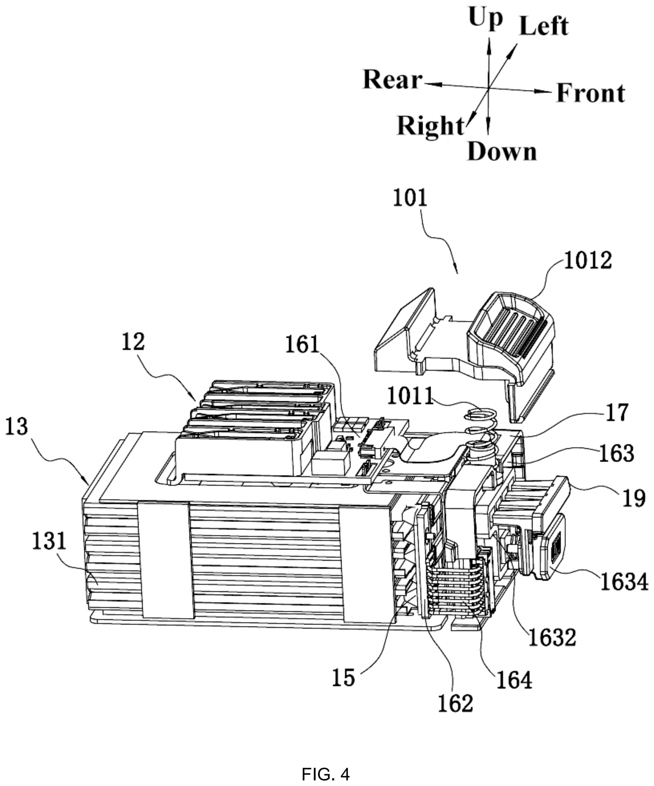

The cell module 13 may include multiple cell units 131. As shown in FIG. 4, each of the cell units 131 may be a pouch cell, which is generally referred to as a soft pack. The multiple battery units 131 are stacked to form the cell module 13. In an example, the cell unit 131 further includes an encapsulation member configured to encapsulate the cell unit 131 so that a compound in the cell unit 131 is prevented from leaking. The encapsulation member includes but is not limited to an aluminum plastic film. In an example, the cell units 131 may be connected in series, or connected in parallel, or connected in series and in parallel.

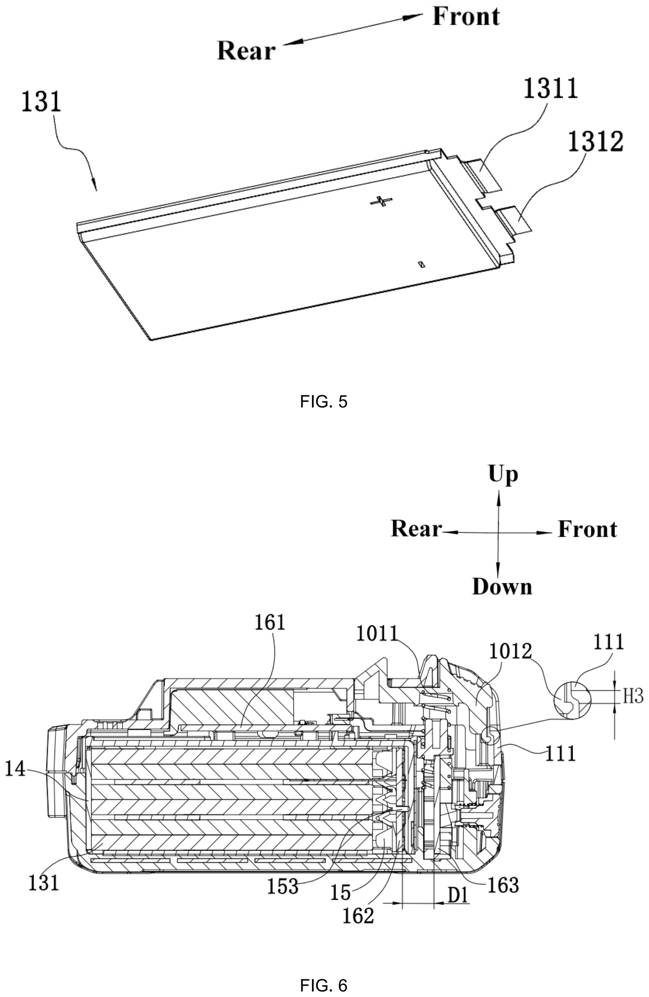

Referring to FIG. 5, a first tab 1311 and a second tab 1312 extend from the front end of each cell unit 131. The first tab 1311 may be one of a positive tab or a negative tab, and the second tab 1312 may be the other of the positive tab or the negative tab. The direction shown in the figure is used as an example, and the first tab 1311 and the second tab 1312 are disposed at the front end of the cell unit 131. In this example, the first tab 1311 and the second tab 1312 are made of different materials.

In an example, at least the opening direction of each of the insertion slots 1111 is different from the extension direction of the first tab 1311 and the extension direction of the second tab 1312. Referring to FIGS. 3 to 6, the openings of the insertion slots 1111 in this example face backward, and the first tab 1311 and the second tab 1312 extend forward. That is, the opening directions of the insertion slots 1111 are opposite to the extension direction of the first tab 1311 and the extension direction of the second tab 1312. In this example, a tab circuit board 162 and a battery management circuit board 163 are each disposed in front of the first tab 1311 and the second tab 1312. A light-emitting member 1631 is disposed on the battery management circuit board 163. Thus, the battery pack 10 can be coupled to the power tool 20 or other electrical equipment along a direction away from the light emission direction of the light-emitting member 1631 so that the light-emitting member 1631 is not shielded when the battery pack 10 is mounted.

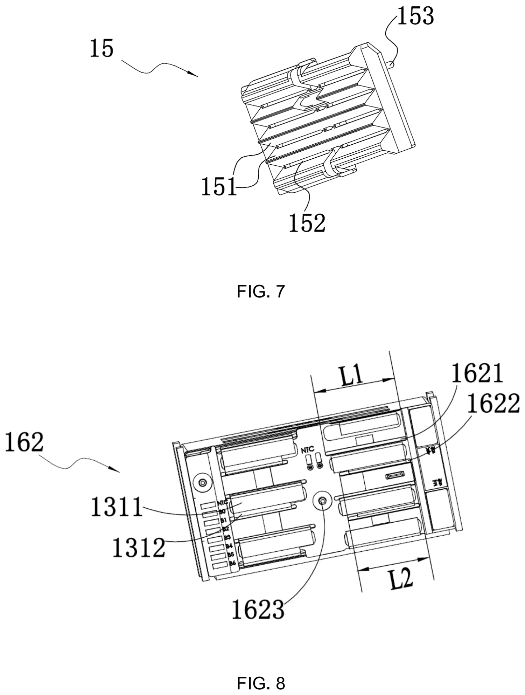

In an example, referring to FIGS. 6 and 7, a guide structure 15 is disposed at the front end of the cell module 13. That is to say, the guide structure 15 is disposed in the extension direction of the first tab 1311 and the extension direction of the second tab 1312. The guide structure 15 can guide the first tab 1311 and the second tab 1312 or can support the tab circuit board 162 coupled to the first tab 1311 and the second tab 1312 when the first tab 1311 and the second tab 1312 are welded, thereby facilitating welding. In an example, two guide surfaces 151 having a substantially V-shaped cross section are provided at an end of the guide structure 15 facing the cell module 13. A guide gap 152 is formed and clamped by the two guide surfaces 151. The first tab 1311 and the second tab 1312 pass through the guide gap 152. At least one fixing portion 153 is disposed at an end of the guide plate 15 facing away from the cell module 13. The fixing portion 153 may have a columnar structure and can pass through the tab circuit board 162 and then abut against or engage with the cell bracket 14, thereby ensuring the firmness of the guide structure 15 in the cell bracket 14.

Referring to FIGS. 3 and 6, a circuit board assembly 16 is disposed in the battery pack 10. In some examples, the circuit board assembly 16 may include one circuit board, and all electrical connections or circuits in the battery pack 10 are established on the circuit board. However, this may result in complex lines within the battery pack and impose extremely high requirements on the performance of the circuit board or components. In some examples, the circuit board assembly 16 may include two circuit boards. One of the two circuit boards is used as a high-power circuit board for carrying total outputted electric energy, and the other of the two circuit boards is used as a circuit board for supporting or carrying low-power components in the battery pack. In this example, the circuit board assembly 16 may include an output circuit board 161, the tab circuit board 162, and the battery management circuit board 163. The circuit board connected to tabs is separated from the circuit board for managing the charge and discharge of the battery pack, or the circuit board on which other low-power components operate is separated from the output circuit board that copes with high-power output. Thus, the complexity of wiring within the battery pack can be reduced, and the service lives of electronic components and circuit boards within the battery pack can be ensured.

In this example, the output circuit board 161 is located at the upper end of the cell bracket 14 and can be electrically coupled to the cell module 13 to transmit the electric energy of the battery pack 10 to the terminal assembly 12. In this example, the terminal assembly 12 is disposed on the output circuit board 161. In other examples, the output circuit board 161 may also be referred to as a main power board.

The tab circuit board 162 is configured to be electrically coupled to the first tab 1311 and the second tab 1312. In this example, the tab circuit board 162 is disposed at the front end of the cell module 13 and is substantially perpendicular to the output circuit board 161. The tab circuit board 162 is provided with multiple slots configured to be penetrated through by the tabs. As shown in FIG. 8, the tab circuit board 162 is provided with a first slot 1621 through which the first tab 1311 penetrates and a second slot 1622 through which the second tab 1312 penetrates. In this example, the slot length L1 of the first slot 1621 is substantially equal to the width of the first tab 1311, and the slot length L2 of the second slot 1622 is substantially equal to the width of the second tab 1312, thereby ensuring the firmness with which the first tab 1311 and the second tab 1312 are electrically coupled to the tab circuit board 162. In this example, the slot length L1 of the first slot 1621 is different from the slot length L2 of the second slot 1622. In an example, the first tab 1311 is a positive tab, the second tab 1312 is a negative tab, and the slot length L1 of the first slot 1621 is greater than the slot length L2 of the second slot 1622. In an example, the first tab 1311 is a negative tab, the second tab 1312 is a positive tab, and the slot length L1 of the first slot 1621 is greater than the slot length L2 of the second slot 1622.

In this example, the tab circuit board 162 is disposed at the front end of the guide structure 15, and the first tab 1311 and the second tab 1312 led out from the guide structure 15 pass through slots on the tab circuit board 162 and then are electrically coupled to the tab circuit board 162. In an implementation, the guiding structure 15 is at least partially attached to the tab circuit board 162. The tab circuit board 162 is provided with a fixing hole 1623 for the fixing portion 153 of the guide structure 15 to penetrate through.

The battery management circuit board 163 carries at least a battery management module of the battery pack 10 and may also be referred to as a battery management system (BMS) board. In this example, the tab circuit board 162 is connected to the output circuit board 161 through an electrical connection sheet, and the tab circuit board 162 is connected to the battery management circuit board 163 through a single-cell signal line 164. In this example, the battery management circuit board 163 is mounted at the front end of the tab circuit board 162 and is substantially parallel to the tab circuit board 162. Referring to FIG. 6, the distance D1 between the battery management circuit board 163 and the tab circuit board 162 is less than or equal to 10 mm. For example, D1 is less than or equal to 9 mm, or less than or equal to 8 mm, or less than or equal to 7 mm. Referring to FIG. 4, the minimum length L3 of the single-cell signal line 164 is less than or equal to 30 mm, or less than or equal to 25 mm, or less than or equal to 20 mm, and so on.

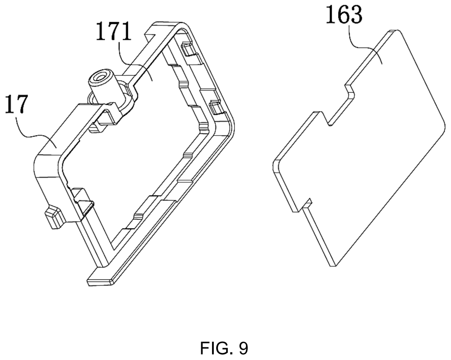

As shown in FIGS. 4 and 9, a circuit board support 17 is further disposed in the battery pack 10 and is at least configured to support the battery management circuit board 163. In this example, the circuit board support 17 is configured to surround the periphery of the battery management circuit board 163, that is to say, the battery management circuit board 163 is fixed within a mounting range 171 formed by the circuit board support 17. As shown in FIG. 4, the battery pack 10 further includes a latch assembly 101. The latch assembly 101 can fix the battery pack 10 to the power tool 20, or the charger, or the adapter. The latch assembly 101 includes at least an elastic member 1011 and an operation member 1012 for a user to operate. The elastic member 1011 may be fixed or mounted on the circuit board support 17, and the operation member 1012 is located above the elastic member 1011. Reference may be made to the description of the latch assembly 101 for fixing the battery pack 10 to the power tool 20 in the related art, and the details are not repeated here.

Referring to FIG. 6, in the process where the operation member 1012 is assembled to the upper housing 111 from bottom to top, an effective interference distance H3 is less than or equal to 2 mm, or less than or equal to 1.5 mm, or less than or equal to 1 mm.

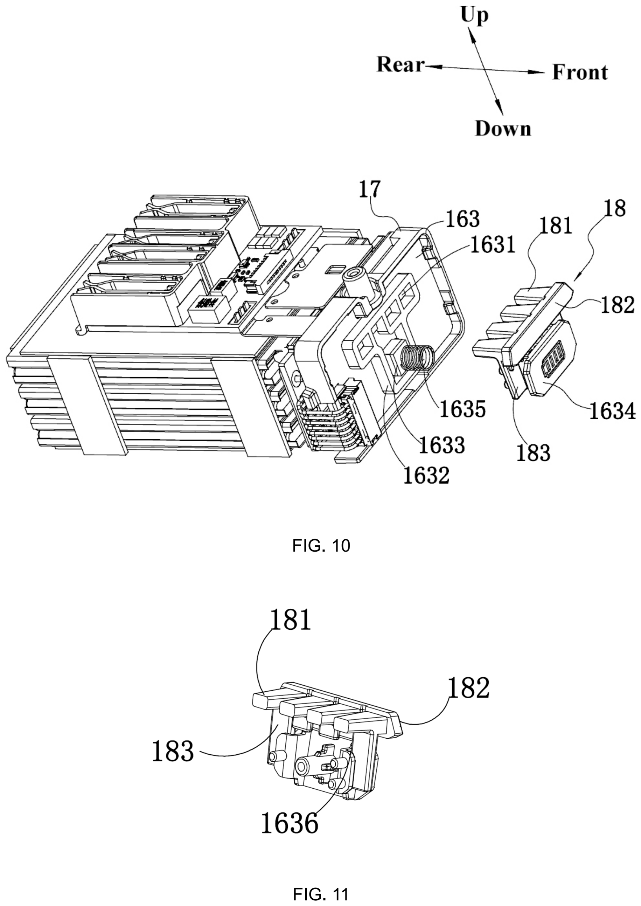

As shown in FIG. 10, multiple light-emitting members 1631 are disposed on the front surface of the battery management circuit board 163 or at the front end of the battery management circuit board 163. The light-emitting members 1631 may be light-emitting diode (LED) lamps or other light-emitting elements. In this example, a sponge 1632 is further disposed on the front surface of the battery management circuit board 163. The sponge 1632 is formed with at least multiple independent enclosures. The number of the enclosures is the same as the number of the light-emitting members 1631 so that the multiple light-emitting members 1631 are isolated separately. To fix the light-emitting members 1631 and the sponge 1632, a respective light-emitting member 1631 and the sponge 1632 may be fixed in each independent enclosure of the sponge 1632 with at least a light-transmissive sponge sealant. In this example, the enclosures formed by the sponge 1632 can isolate the light from the light-emitting members 1631 so as to avoid optical crosstalk between the multiple light-emitting members 1631. In an example, an electronic display switch 1633 is further disposed on the battery management circuit board 163, and the electronic display switch 1633 can at least control the light-emitting members 1631 to emit light. In an example, the electronic display switch 1633 and any one of the light-emitting members 1631 may be both disposed in an enclosure formed by the sponge 1632. An adhesive dispensed to the light-emitting member 1631 may flow to the electronic display switch 1633. The electronic display switch 1633 is fixed by using the flowing dispensed adhesive without affecting the use of the electronic display switch 1633 due to an excessive dispensed adhesive. In other examples, the electronic display switch 1633 may be disposed in an independent enclosure formed by the sponge 1632.

With continued reference to FIG. 10, an electronic display button 1634 is disposed directly in front of the electronic display switch 1633, and the user may operate the electronic display button 1634 to control the electronic display switch 1633 to be on or off. At least a spring 1635 is disposed between the electronic display switch 1633 and the electronic display button 1634 to reset the electronic display button 1634. In this example, to guide the light from the light-emitting members 1631, the battery pack 10 is further provided with a light guide member 18. Referring to FIGS. 10 and 11, the light guide member 18 includes multiple light guide columns 181. The number of the light guide columns 181 is the same as the number of the light-emitting members 1631. One end of each of the light guide columns 181 faces a respective light-emitting member 1631, and the other ends of the light guide columns 181 collectively form a light emission surface 182 to display the light emission state of each of the light-emitting members 1631. In this example, the light guide member 18 is further provided with limit ribs 183 configured to limit the electronic display button 1634. Correspondingly, the electronic display button 1634 is formed or provided with limit grooves 1636, and the limit ribs 183 are mounted in the limit grooves 1636 from top to bottom. The light guide member 18 is ingeniously used for limiting the electronic display button 1634. Thus, parts in the battery pack 10 are reduced on the basis of ensuring that the electronic display button 1634 is mounted stably.

The basic principles, main features, and advantages of this application are shown and described above. It is to be understood by those skilled in the art that the aforementioned examples do not limit the present application in any form, and all technical solutions obtained through equivalent substitutions or equivalent transformations fall within the scope of the present application.

## Claims

1. A battery pack for powering a power tool, comprising:
a housing, wherein a plurality of insertion slots are provided at an upper end of the housing;
a terminal assembly disposed in the housing and comprising a plurality of battery terminals, wherein positions where the plurality of battery terminals are mounted in the housing correspond to the plurality of insertion slots; and
a cell module accommodated in the housing, wherein the cell module comprises at least a plurality of cell units, and a first tab and a second tab extend from an end of each of the plurality of cell units;
wherein an opening direction of each of the plurality of insertion slots is opposite to an extension direction of the first tab and an extension direction of the second tab.

2. The battery pack according to claim 1, further comprising: a cell bracket configured to wrap at least part of the cell module; the output circuit board disposed at an upper end of the cell bracket; the tab circuit board disposed at a front end of the cell module and substantially perpendicular to the output circuit board; and the battery management circuit board disposed in front of the tab circuit board and substantially parallel to the tab circuit board.

3. The battery pack according to claim 1, further comprising a circuit board support, wherein the circuit board support is configured to surround a periphery of a battery management circuit board to support the battery management circuit board.

4. The battery pack according to claim 3, further comprising a latch assembly configured to be capable of locking at least the battery pack to the power tool, wherein the latch assembly comprises an elastic member and an operation member for a user to operate, and the elastic member is mounted on the circuit board support.

5. The battery pack according to claim 4, wherein an effective interference stroke by which the operation member is mounted to the housing is less than or equal to 2 mm.

6. The battery pack according to claim 1, further comprising a circuit board assembly, wherein the circuit board assembly comprises: an output circuit board connected to at least the terminal assembly to carry outputted electric energy of the battery pack; a tab circuit board electrically coupled to at least the first tab and the second tab; and a battery management circuit board carrying at least a battery management module of the battery pack.

7. The battery pack according to claim 6, wherein a distance range between the tab circuit board and the battery management circuit board is less than or equal to 10 mm.

8. The battery pack according to claim 6, wherein a single-cell signal line is connected between the tab circuit board and the battery management circuit board, and a length of the single-cell signal line is less than or equal to 30 mm.

9. The battery pack according to claim 1, further comprising: a plurality of light-emitting members disposed on a battery management circuit board; a light guide member at least partially located on the plurality of light-emitting members; and an electronic display button mounted on the housing and used by a user to operate an electronic display element on the battery management circuit board, wherein the light guide member is formed with a limit rib to limit the electronic display button.

10. The battery pack according to claim 6, further comprising a sponge disposed on the battery management circuit board, wherein the sponge is configured to isolate at least the plurality of light-emitting members.

11. The battery pack according to claim 1, wherein a ratio of an opening width of each of the plurality of insertion slots to a distance between two adjacent slots is less than or equal to 0.2.

12. The battery pack according to claim 1, wherein the battery pack is continuously discharged at a discharge rate of greater than or equal to 30 C at room temperature for a period of longer than or equal to 20s.

13. The battery pack according to claim 1, wherein an energy density per unit volume of the battery pack is greater than or equal to 110 mWh/cm³.

14. The battery pack according to claim 1, wherein an energy density per unit height of the battery pack in an up and down direction is greater than or equal to 950 mWh/mm.

15. The battery pack according to claim 1, wherein the plurality of cell units are pouch cells.

16. The battery pack according to claim 1, wherein at least a bottom of the housing is provided with a stiffener.

17. The battery pack according to claim 16, wherein a ratio of a surface area of the stiffener to an area of the bottom of the housing is less than 1.

18. The battery pack according to claim 16, wherein a ratio of a thickness of the stiffener to a thickness of the bottom of the housing is less than or equal to 0.4.

19. The battery pack according to claim 16, wherein the stiffener is embedded in the bottom of the housing.

20. The battery pack according to claim 1, wherein a tab extends from the end of each of the plurality of cell units, and the battery pack further comprises a guide structure, wherein the guide structure is disposed at a front end of the tab in an extension direction to guide or support the tab.

21. A battery pack for powering a power tool, comprising:
a housing;
a terminal assembly configured to be connected to a tool terminal of the power tool to transmit electric energy;
a cell module accommodated in the housing, wherein the cell module comprises at least a plurality of cell units, and each of the plurality of cell units has a first tab and a second tab; and
a circuit board assembly, wherein the circuit board assembly comprises:
an output circuit board connected to at least the terminal assembly to carry outputted electric energy of the battery pack;
a tab circuit board electrically coupled to at least the first tab and the second tab; and
a battery management circuit board carrying at least a battery management module of the battery pack;
wherein the tab circuit board is provided with a first slot through which the first tab penetrates and a second slot through which the second tab penetrates; and
a length of the first slot is different from a length of the second slot.

22. A battery pack, comprising:
a housing;
a terminal assembly configured to be connected to a tool terminal of the power tool to transmit electric energy; and
a cell module accommodated in the housing, wherein the cell module comprises at least a plurality of cell units;
wherein
the plurality of cell units are pouch cells; and
the battery pack is continuously discharged at a discharge rate of greater than or equal to 30 C at room temperature for a period of longer than or equal to 20s.

23. A battery pack for powering a power tool, comprising:
a housing;
a terminal assembly configured to be connected to a tool terminal of the power tool to transmit electric energy; and
a cell module accommodated in the housing and electrically connected to the terminal assembly, wherein the cell module comprises at least a plurality of cell units;
wherein an energy density per unit volume of the battery pack is greater than or equal to 110 mWh/cm³.

24. The battery pack according to claim 23, wherein an energy density per unit height of the battery pack in an up and down direction is greater than or equal to 950 mWh/mm.

25. The battery pack according to claim 23, wherein the plurality of cell units are pouch cells.

26. The battery pack according to claim 23, wherein at least a bottom of the housing is provided with a stiffener.

27. The battery pack according to claim 26, wherein a ratio of a surface area of the stiffener to an area of the bottom of the housing is less than 1.

28. The battery pack according to claim 26, wherein a ratio of a thickness of the stiffener to a thickness of the bottom of the housing is less than or equal to 0.4.

29. The battery pack according to claim 26, wherein the stiffener is embedded in the bottom of the housing.

30. The battery pack according to claim 23, wherein a tab extends from an end of each of the plurality of cell units, and the battery pack further comprises a guide structure, wherein the guide structure is disposed at a front end of the tab in an extension direction to guide or support the tab.
